# EUROPEAN PATENT APPLICATION

(11) **EP 4 654 801 A1**
(43) Date of publication of application: **26.11.2025**
(21) Application number: 23918708.1
(22) Date of filing: 27.01.2023
(51) Int. Cl.: H10K 59/80, H05K 7/20, G06F 1/20

(54) **DISPLAY DEVICE**

(71) Applicant: LG Electronics Inc., Yeongdeungpo-gu Seoul 07336 (KR)
(72) Inventor: KIM, Minsoo, Seoul 06772 (KR); CHOI, Haesuk, Seoul 06772 (KR); LEE, Jaegi, Seoul 06772 (KR); LEE, Youngmin, Seoul 06772 (KR)
(74) Representative: Schott, Jakob Valentin
(86) International application number: PCT/KR2023/001242
(87) International publication number: WO 2024/158072

(57) **Abstract**

Disclosed is a display device. The display device of the present disclosure may include: a display panel; a frame which is positioned behind the display panel and to which the display panel is coupled; a board coupled to the rear surface of the frame; a channel which is the flow path of air between the display panel and the frame and which overlaps the board in the thickness direction of the frame; and a fan opposite the channel with respect to the frame and having an inlet facing the channel, wherein the frame may include: an inlet hole formed in the frame and communicating with the channel; and a discharge hole formed in the frame, spaced apart from the inlet hole, and positioned between the channel and the inlet of the fan.

## Description

### TECHNICAL FIELD

The present disclosure relates to a display device.

### BACKGROUND ART

With the development of information society, there has been a growing demand for various types of display devices. In order to meet such demand, various display devices, such as a liquid crystal display (LCD) device, a plasma display panel (PDP), an electro luminescent display (ELD), a vacuum fluorescent display (VFD), an organic light emitting diode (OLED) display, and the like, have been developed and used.

Among them, a display device using an organic light emitting diode (OLED) has excellent luminance and viewing angle characteristics compared to a liquid crystal display device, and requires no backlight unit, which is advantageous to achieve an ultra-thin profile.

Recently, numerous research has been conducted on structures that can effectively remove heat generated due to high-luminance or high-resolution image output in large screen ultra-thin display devices.

### DETAILED DESCRIPTION OF INVENTION

### TECHNICAL PROBLEMS

It is an object of the present disclosure to solve the above and other problems.

Another object may be to provide a display device that can minimize an excessive increase in temperature of a display panel due to heat generated from a board on which a heating element is mounted.

Another object may be to provide a structure for generating an airflow that passes between a display panel and a frame.

### TECHNICAL SOLUTION

In accordance with an aspect of the present disclosure for achieving the above and other objects, a display device may include: a display panel; a frame which is positioned behind the display panel and to which the display panel is coupled; a board coupled to a rear surface of the frame; a channel which is an air flow path between the display panel and the frame, and which overlaps the board in a thickness direction of the frame; and a fan positioned opposite the channel with respect to the frame and having an inlet facing the channel, wherein the frame may include: an inlet hole formed in the frame and communicating with the channel; and a discharge hole formed in the frame, spaced apart from the inlet hole, and positioned between the channel and the inlet of the fan.

### EFFECT OF INVENTION

A display device according to the present disclosure has the following effects.

According to at least one of the embodiments of the present disclosure, it is possible to provide a display device capable of minimizing an excessive increase in temperature of a display panel due to heat generated from a board on which a heating element is mounted.

According to at least one of the embodiments of the present disclosure, it is possible to provide a structure for generating an airflow that passes between a display panel and a frame.

Further scope of applicability of the present disclosure will become apparent from the following detailed description. However, it should be understood that the detailed description and specific embodiments such as preferred embodiments of the present disclosure are given by way of example only, since various changes and modifications within the idea and scope of the present disclosure may be clearly understood by those skilled in the art.

### BRIEF DESCRIPTION OF THE DRAWING

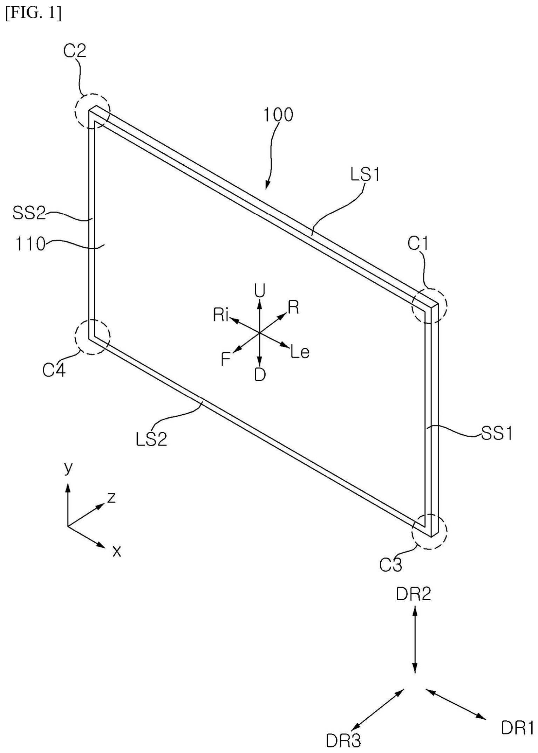

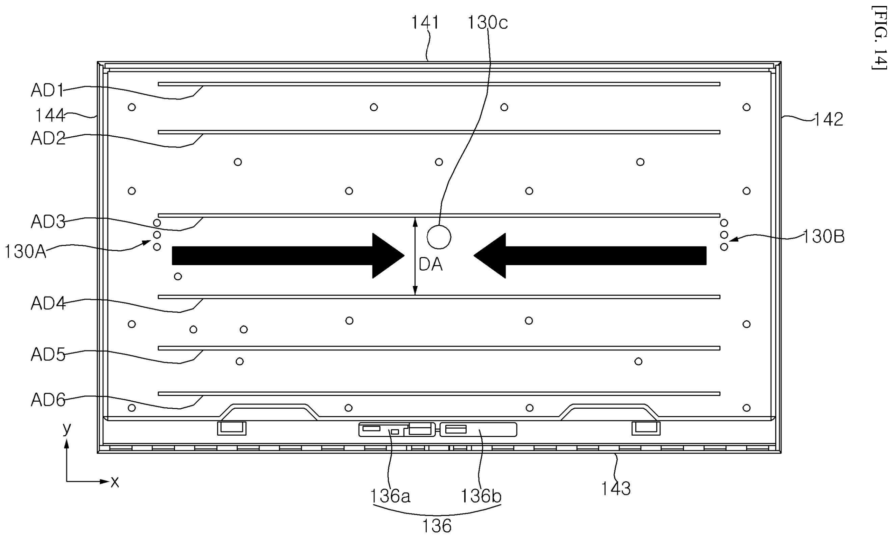

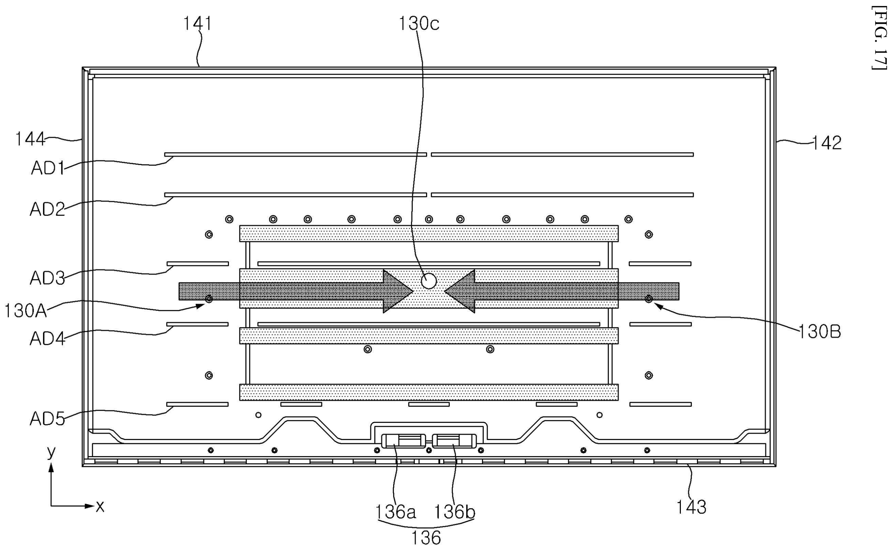

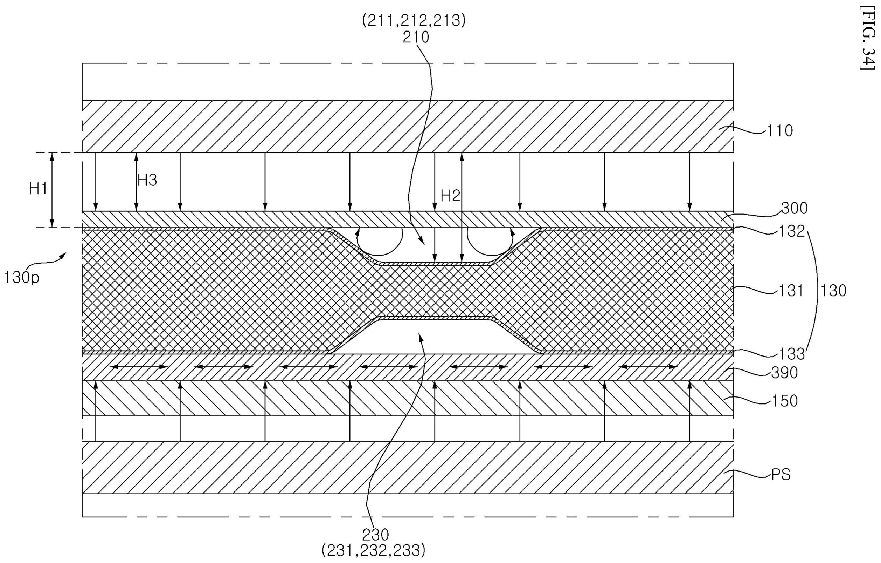

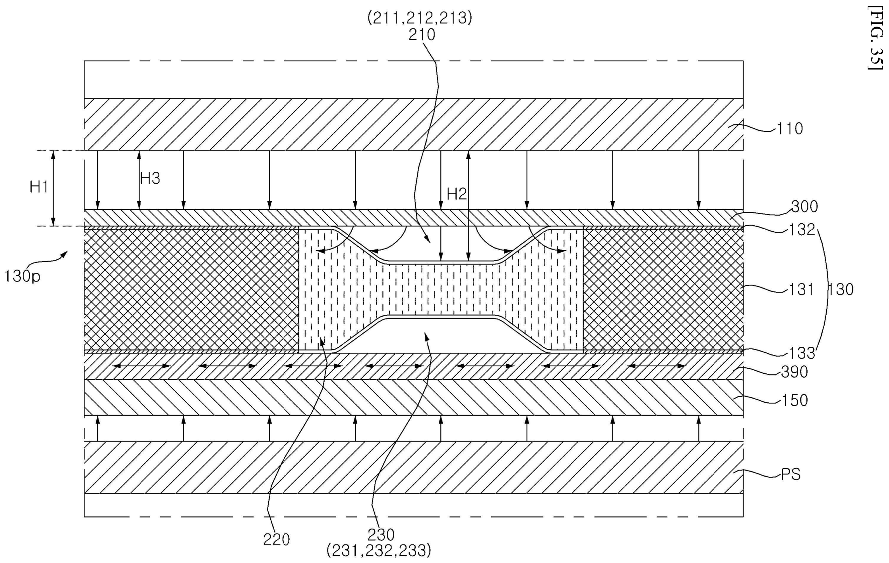

FIGS. 1 to 35 are diagrams illustrating examples of a display device according to embodiments of the present disclosure.

### MODE FOR CARRYING OUT THE INVENTION

Description will now be given in detail according to exemplary embodiments disclosed herein, with reference to the accompanying drawings. For the sake of brief description with reference to the drawings, the same or equivalent components may be denoted by the same reference numbers, and description thereof will not be repeated.

In the following description, a suffix such as "module" and "unit" may be used to refer to elements or components. Use of such a suffix herein is merely intended to facilitate description of the specification, and the suffix itself is not intended to give any special meaning or function.

In the present disclosure, that which is well known to one of ordinary skill in the relevant art has generally been omitted for the sake of brevity. The accompanying drawings are used to help easily understand various technical features and it should be understood that the embodiments disclosed herein are not limited by the accompanying drawings. As such, the present disclosure should be construed to extend to any alterations, equivalents, and substitutes in addition to those which are particularly set out in the accompanying drawings.

Although the terms "first", "second", etc. may be used herein to describe various elements, these elements should not be limited by these terms. These terms are only used to distinguish one element from another.

It will be understood that when a component is referred to as being "coupled" or "connected" to another component, it may be directly coupled or connected to another component, or intervening components may be present. In contrast, when a component is referred to as being "directly coupled" or "directly connected" to another component, there are no intervening components present.

A singular representation may include a plural representation unless the context clearly indicates otherwise.

Terms such as "comprises or includes" or "has" are used herein and should be understood that they are intended to indicate an existence of features, numbers, steps, operations, elements, components, or combinations thereof, disclosed in the specification, but do not preclude the presence or addition of one or more other features, numbers, steps, operations, elements, components, or combinations thereof.

The directions "up (U)", "down (D)", "left (Le)", "right (Ri)", "front (F)", and "rear (R)" shown in the drawings are used only for convenience of description, and the technical concept disclosed in this specification is not limited by these directions.

Referring to FIG. 1, a display device 100 may include a display panel 110. The display panel 110 may display an image.

The display device 100 may include a first long side LS1, a second long side LS2 opposite the first long side LS1, a first short side SS1 adjacent to the first long side LS1 and the second long side LS2, and a second short side SS2 opposite the first short side SS1.

For ease of explanation, it is illustrated and described that lengths of the first and second long sides LS1 and LS2 are greater than lengths of the first and second short sides SS1 and SS2, but the lengths of the first and second long sides LS1 and LS2 may be substantially equal to the lengths of the first and second short sides SS1 and SS2.

A direction parallel to the long sides LS1 and LS2 may be referred to as a first direction DR1 or a left-right direction. A direction parallel to the short sides SS1 and SS2 may be referred to as a second direction DR2 or an up-down direction. A direction perpendicular to the long sides LS1 and LS2 and the short sides SS1 and SS2 may be referred to as a third direction DR3 or a front-rear direction.

A direction in which the display panel 110 displays an image may be referred to as a front (F), and a direction opposite to the front may be referred to as a rear (R, z). The first short side SS1 may be referred to as a left side (Le, x). The second short side SS2 may be referred to as a right side (Ri). The first long side LS1 may be referred to as an upper side (U, y). The second long side LS2 may be referred to as a lower side (D).

The first long side LS1, the second long side LS2, the first short side SS1, and the second short side SS2 may be referred to as edges of the display device 100.

A point where the first long side LS1 and the first short side SS1 meet may be referred to as a first corner C1. A point where the first long side LS1 and the second short side SS2 meet may be referred to as a second corner C2. A point where the second long side LS2 and the first short side SS1 meet may be referred to as a third corner C3. A point where the second long side LS2 and the second short side SS2 meet may be referred to as a fourth corner C4.

Hereinafter, a display panel using an organic light emitting diode (OLED) will be described as an example for the display panel 110, but the display panel 110 applicable to the present disclosure is not limited thereto.

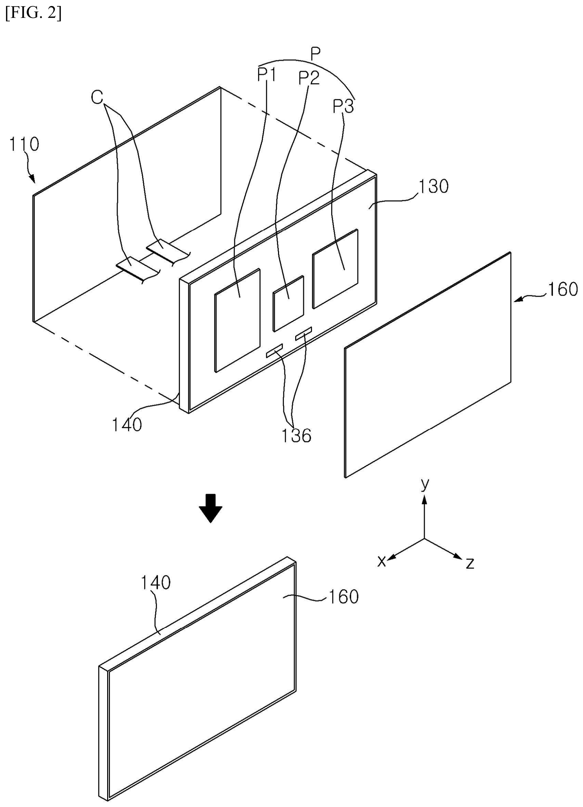

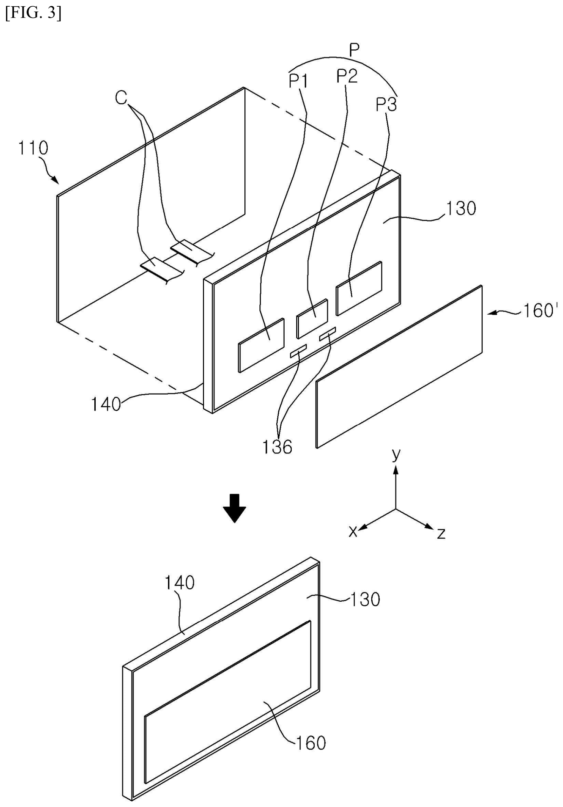

Referring to FIGS. 2 and 3, the display panel 110 may define a front surface of the display device 100, and may display an image to the front. The display panel 110 may include a plurality of pixels to output an image in accordance with color, brightness, and chroma of each pixel. The display panel 110 may be divided into an active area in which an image is displayed and a de-active area in which no image is displayed. The display panel 110 may generate light corresponding to red, green, or blue color in response to a control signal.

A frame 130 may be positioned at the rear of the display panel 110, and may be coupled to the display panel 110. The frame 130 may be referred to as a module cover 130 or a cover bottom 130.

A guide panel 140 may extend along a periphery of the display panel 110. The guide panel 140 may be positioned between the display panel 110 and the frame 130, and may be coupled to the frame 130. The guide panel 140 may be referred to as a side frame 140 or a middle cabinet 140.

A plurality of boards P1, P2, and P3 may be coupled to a rear surface of the frame 130, and may be electrically connected to electronic components of the display device. The board P may be a printed circuit board (PCB), and electronic elements may be mounted on the board P.

A power supply board P1 may provide power to each component of the display device. A timing controller board P2 may provide an image (or video) signal to the display panel 110. A main board P3 may control each component of the display device. For example, the power supply board P1 may be adjacent to a left side of the frame 130, the main board P3 may be adjacent to a right side of the frame 130, and the timing controller board P2 may be positioned between the power supply board P1 and the main board P3.

A source PCB may be adjacent to a lower side of the display panel 110, and may be coupled to a rear surface of the display panel 110. The source PCB may be electrically connected to the display panel 110 and a cable C. The cable C may pass through a cable hole 136 formed in the frame 130, and may be electrically connected to the timing controller board P2. For example, the cable C may be a flexible flat cable (FFC).

A back cover 160 may be disposed at the rear of the frame 130, and may be coupled to the frame 130. The board P may be positioned between the frame 130 and the back cover 160, and may be covered by the back cover 160. For example, the back cover 160 may have an area corresponding to the frame 130, and may cover all or most of the rear surface of the frame 130 (refer to FIG. 2). As another example, a back cover 160' may have a smaller area than the frame 130, and may cover a portion of the rear surface of the frame 130 (refer to FIG. 3). In this case, the size and position of the back cover 160' may be determined to correspond to a region occupied by the board P on the frame 130.

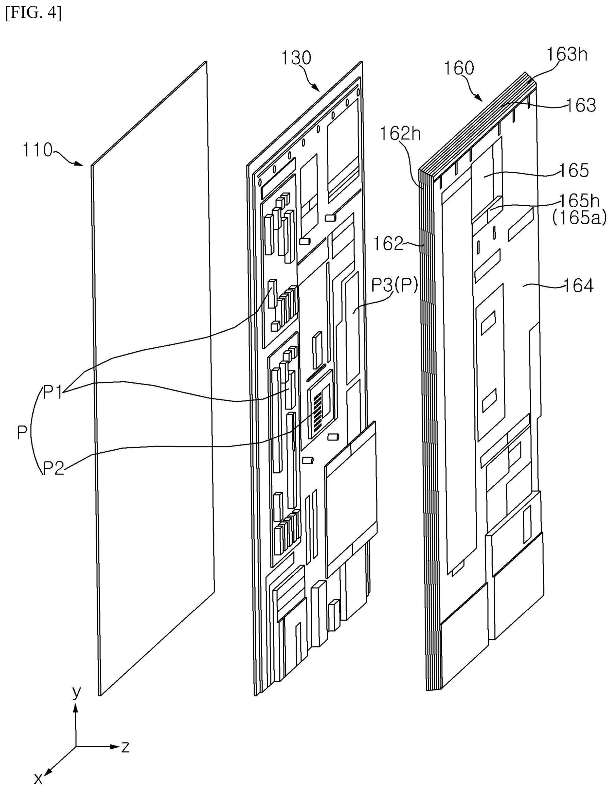

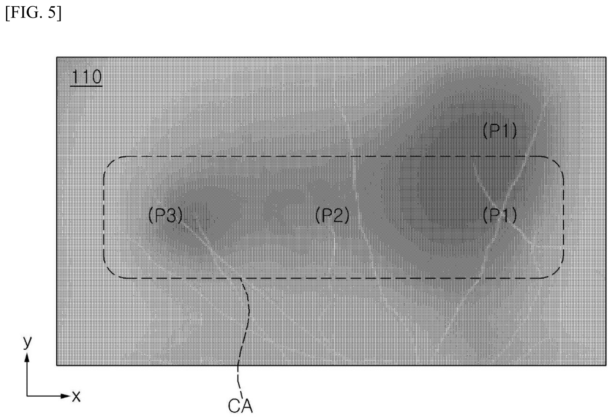

Referring to FIGS. 4 and 5, heat from the board P may be transferred to the display panel 110 through the frame 130, thereby causing an increase in temperature of the display panel 110. A region of the display panel 110 that corresponds to the board P may have a higher temperature than other regions of the display panel 110. For example, the plurality of boards P1, P2, and P3 may be horizontally arranged at a central portion of the rear surface of the frame 130, and the temperature of a horizontal region CA at a central portion of the front surface of the display panel 110 may be higher than the temperature of other regions of the display panel 110. Here, in a thickness direction of the display device, namely, in the front-rear direction, the region CA may overlap with a region of the frame 130 in which the plurality of boards P1, P2, and P3 are arranged.

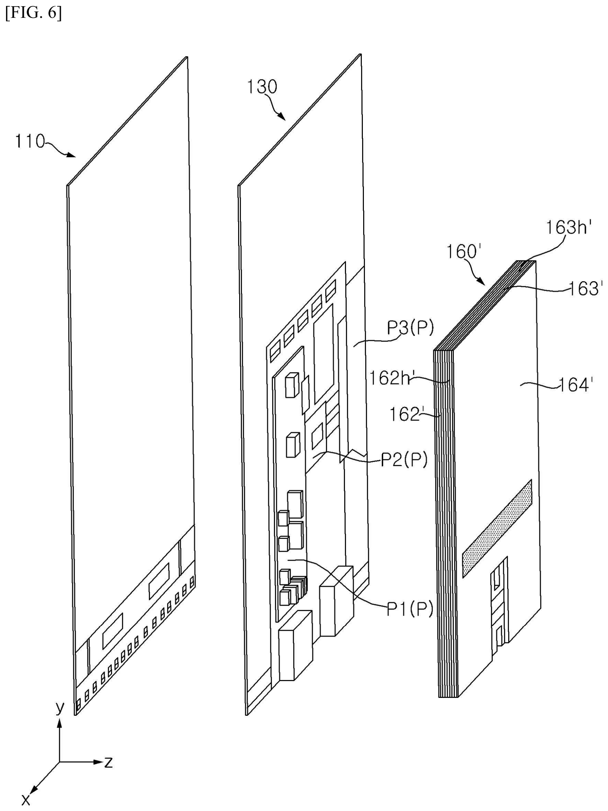

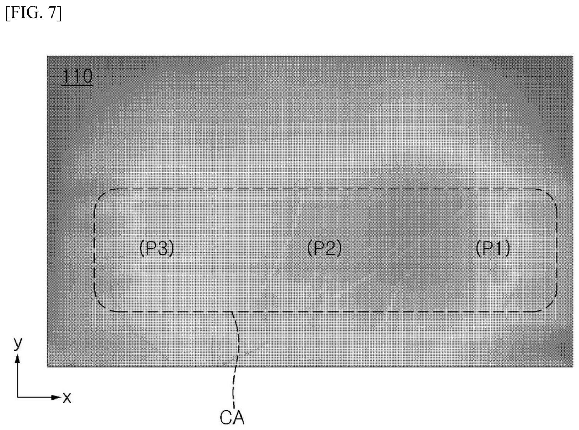

Referring to FIGS. 6 and 7, heat from the board P may be transferred to the display panel 110 through the frame 130, thereby causing an increase in temperature of the display panel 110. A region of the display panel 110 that corresponds to the board P may have a higher temperature than other regions thereof. For example, the plurality of boards P1, P2, and P3 may be horizontally arranged at or below a central portion of the rear surface of the frame 130, and the temperature of a horizontal region CA at or below a central portion of the front surface of the display panel 110 may be higher than the temperature of other regions of the display panel 110. Here, in a thickness direction of the display device, namely, in the front-rear direction, the region CA may overlap with a region of the frame 130 in which the plurality of boards P1, P2, and P3 are arranged.

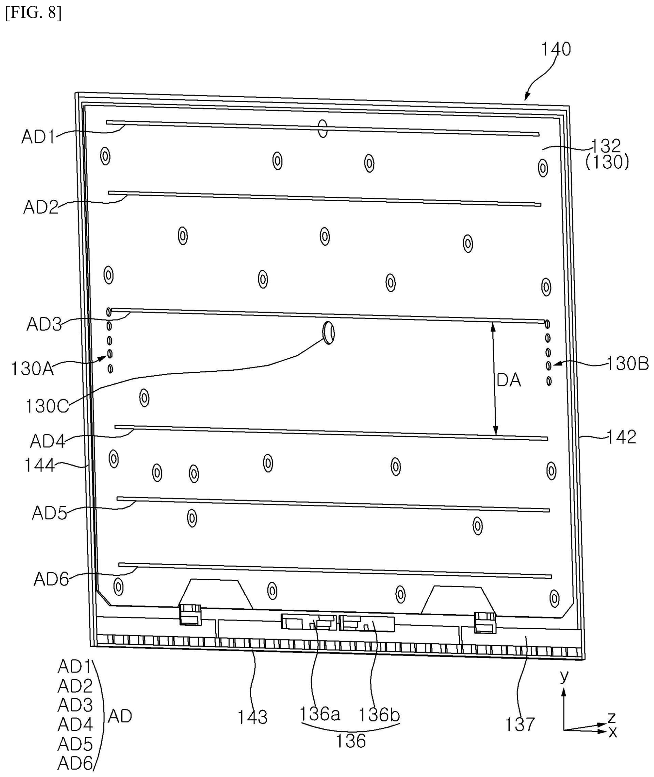

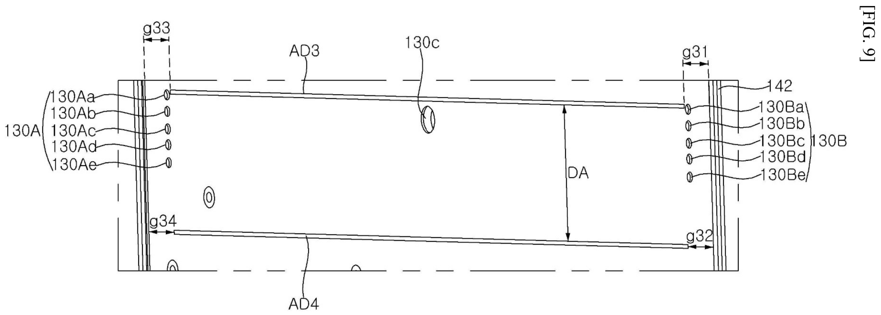

Referring to FIGS. 8 and 9, an adhesive member AD may be attached to a front surface 132 of the frame 130. For example, the adhesive member AD may be a double-sided tape. For example, the adhesive member AD may be a black masking tape. The adhesive member AD may extend horizontally. For example, a plurality of adhesive members AD may be vertically spaced apart from each other. The plurality of adhesive members AD may have the same thickness.

A first adhesive member AD1 may be attached to the front surface 132 adjacent to an upper side of the frame 130, and may extend horizontally.

A second adhesive member AD2 may be positioned below the first adhesive member AD1, may be attached to the front surface 132, and may extend along the first adhesive member AD1.

A third adhesive member AD3 may be positioned opposite the first adhesive member AD1 with respect to the second adhesive member AD2, may be attached to the front surface 132, and may extend along the second adhesive member AD2.

A fourth adhesive member AD4 may be positioned opposite the second adhesive member AD2 with respect to the third adhesive member AD3, may be attached to the front surface 132, and may extend along the third adhesive member AD3.

A fifth adhesive member AD5 may be positioned opposite the third adhesive member AD3 with respect to the fourth adhesive member AD4, may be attached to the front surface 132, and may extend along the fourth adhesive member AD4.

A sixth adhesive member AD6 may be positioned opposite the fourth adhesive member AD4 with respect to the fifth adhesive member AD5, may be attached to the front surface 132, and may extend along the fifth adhesive member AD5.

A channel DA may be formed between the third adhesive member AD3 and the fourth adhesive member AD4. The channel DA may be a horizontally long air flow path. The position of the channel DA may correspond to the region CA (see FIG. 5 and FIG. 7). The channel DA may overlap the region CA in a thickness direction of the frame 130, namely, in the front-rear direction. The channel DA may be referred to as an air flow path DA or a cooling space DA. The third adhesive member AD3 may be referred to as a first protruding portion AD3, and the fourth adhesive member AD4 may be referred to as a second protruding portion AD4.

An inlet hole 130A, 130B may be formed through a portion of the frame 130 between the third adhesive member AD3 and the fourth adhesive member AD4 in the front-rear direction. The inlet hole 130A, 130B may face the channel DA. The inlet hole 130A, 130B may face at least one of both areas (or portions) of the channel DA, and may communicate with the channel DA. A first inlet hole 130A may be adjacent to the right side of the frame 130, and may face the right area of the channel DA. A plurality of first holes 130Aa, 130Ab, 130Ac, 130Ad, and 130Ae may be spaced apart from each other in the vertical direction. Alternatively, the first inlet hole 130A may be elongated vertically. A second inlet hole 130B may be adjacent to the left side of the frame 130, and may face the left area of the channel DA. A plurality of second holes 130Ba, 130Bb, 130Bc, 130Bd, and 130Be may be spaced apart from each other in the vertical direction. Alternatively, the second inlet hole 130B may be elongated vertically.

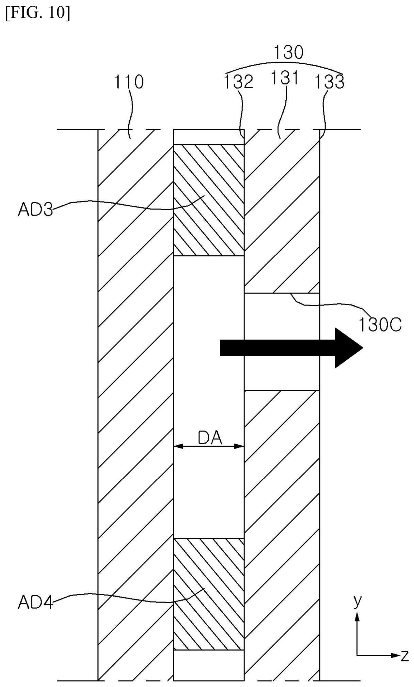

Referring to FIGS. 9 and 10, the rear surface of the display panel 110 may be attached to the adhesive member AD (see FIG. 8). A gap between the rear surface of the display panel 110 and the front surface 132 of the frame 130 may be equal to the thickness of the adhesive member AD.

The boundary of the channel DA may be defined by the rear surface of the display panel 110, the front surface 132 of the frame 130, a lower side of the third adhesive member AD3, and an upper side of the fourth adhesive member AD4.

A discharge (or outlet) hole 130C may be formed through a portion of the frame 130 between the third adhesive member AD3 and the fourth adhesive member AD4 in the front-rear direction. The discharge hole 130C may face a central area of the channel DA. The discharge hole 130C may be adjacent to the third adhesive member AD3 or the fourth adhesive member AD4. Alternatively, the discharge hole 130C may be positioned in the middle of the third adhesive member AD3 and the fourth adhesive member AD4.

The inlet hole 130A, 130B may be aligned with the discharge hole 130C in a longitudinal direction of the channel DA (i.e., the longitudinal direction of the adhesive members AD3 and AD4). For example, in a width direction of the channel DA (i.e., the direction in which the adhesive members AD3 and AD4 are spaced apart from each other), a width of the inlet hole 130A, 130B (or the width of placement area) may be greater than a width (diameter) of the discharge hole 130C.

The plurality of adhesive members AD (see FIG. 8) may partition a space between the rear surface of the display panel 110 and the front surface 132 of the frame 130 into a plurality of spaces. Here, the partitioning may refer not only to a case where one space and another space are configured independently, but also to a case where one space and another space are generally configured independently but communicate with each other through a narrow gap.

For example, the adhesive members AD3 and AD4 may have a length less than a horizontal length of the frame 130. Left ends of the adhesive members AD3 and AD4 may be spaced apart from the left side of the frame 130 (see g31 and g32 in FIG. 9), and right ends of the adhesive members AD3 and AD4 may be spaced apart from the right side of the frame 130 (see g33 and g34 in FIG. 9). That is, the channel DA may communicate with a space above or below the channel DA. The inlet hole 130A, 130B may be positioned to correspond to gaps g31, g32, g33, and g34 between the adhesive members AD3 and AD4 and the left and right sides of the frame 130. In this case, the airflow passing through the inlet hole 130A, 130B may cause entrainment of the air in the space above or below the channel DA into the channel DA.

As another example, the adhesive members AD3 and AD4 may have a length substantially equal to the horizontal length of the frame 130. A gap may (almost) not be formed between the adhesive members AD3 and AD4 and the left and right sides of the frame 130. That is, the channel DA may (almost) not communicate with a space above or below the channel DA. In this case, air may pass through the channel DA that is independent of the space above or below the channel DA, thereby improving cooling performance of a region of the display panel 110 facing the channel DA.

Meanwhile, instead of the third adhesive member AD3 and the fourth adhesive member AD4, a first protruding portion and a second protruding portion may define the boundary of the channel DA. The first protruding portion may protrude from the front surface 132 of the frame 130 toward the display panel 110, and may extend horizontally. For example, the first protruding portion may be formed by being pressed forward from a rear surface 133 of the frame 130. The first protruding portion may be referred to as a first bead or a first forming portion. The second protruding portion may protrude from the front surface 132 of the frame 130 toward the display panel 110, and may extend horizontally. For example, the second protruding portion may be formed by being pressed forward from the rear surface 133 of the frame 130. The second protruding portion may be referred to as a second bead or a second forming portion.

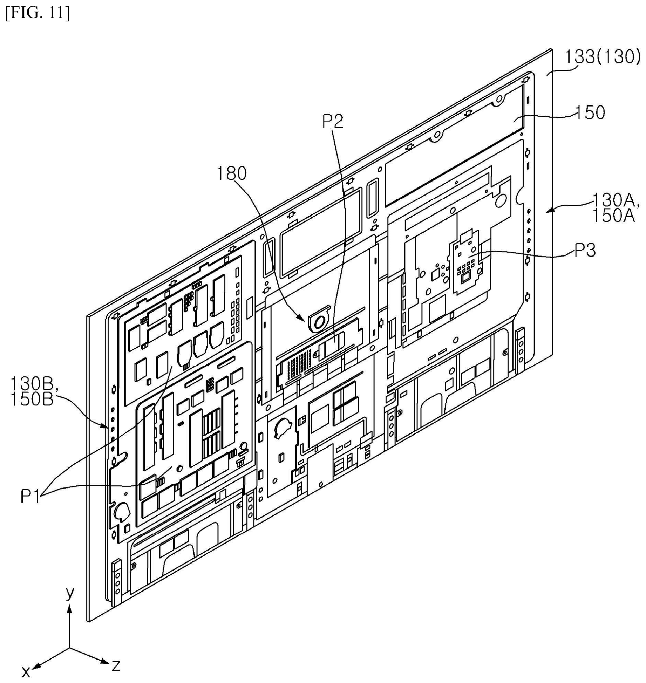

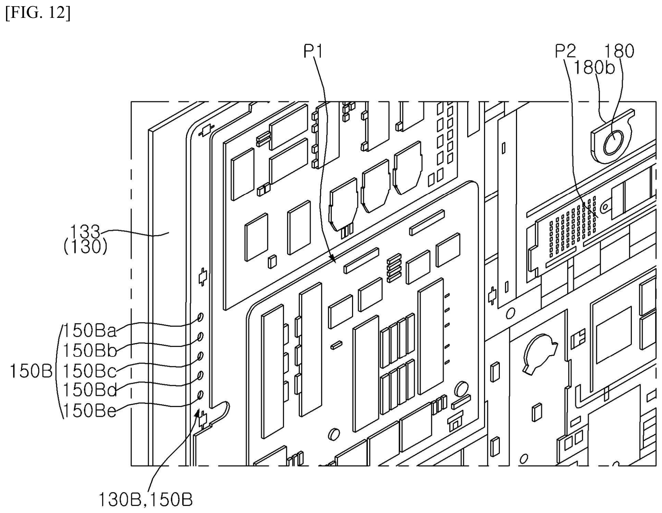

Referring to FIGS. 11 and 12, a mount plate 150 may be coupled to the rear surface 133 of the frame 130. The mount plate 150 may have an area corresponding to the back cover 160 (see FIG. 4). The mount plate 150 may be referred to as a PCB plate 150. A plurality of boards P1, P2, and P3 may be mounted on a rear surface of the mount plate 150. Alternatively, the mount plate 150 may be omitted, and the plurality of boards P1, P2, and P3 may be mounted on the rear surface 133 of the frame 130.

For example, a portion of the mount plate 150 may be disposed in a region where the inlet hole 130A, 130B of the frame 130 are formed. In this case, a through-hole 150A, 150B may be formed through the mount plate 150 in the front-rear direction, and may be aligned with the inlet hole 130A, 130B. In addition, the through-hole 150A, 150B may be provided in plurality, like the inlet hole 130A, 130B (refer to FIG. 12) or may be elongated vertically (not shown).

As another example, the mount plate 150 may be omitted or the mount plate 150 may be disposed beyond the region in which the inlet hole 130A, 130B of the frame 130 are formed.

A fan 180 may be adjacent to the plurality of boards P1, P2, and P3. The fan 180 may be positioned at or near a central portion of a region where the plurality of boards P1, P2, and P3 are disposed. The plurality of boards P1, P2, and P3 may be horizontally arranged at a central portion of the display device, and the fan 180 may be disposed at the central portion of the display device. The fan 180 may be positioned above the timing controller board P2. The fan 180 may cause a flow of air. An inlet of the fan 180 may face the front of the frame 130, and an outlet of the fan 180 may face the rear of the frame 130.

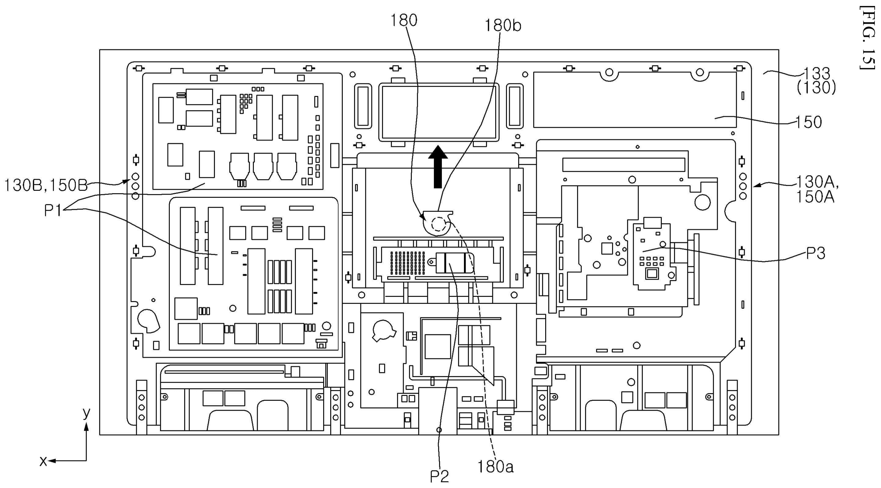

For example, the fan 180 may be mounted on the rear surface of mount plate 150. In this case, an inner hole (not shown) may be formed through the mount plate 150 in the front-rear direction, and may be positioned between the discharge hole 130C (see FIG. 10) and an inlet 180a (see FIG. 15) of the fan 180. Air in the channel DA may be introduced into the inlet 180a of the fan 180 through the discharge hole 130C and the inner hole.

As another example, the fan 180 may be mounted on the rear surface 133 of the frame 130. In this case, the inlet 180a of the fan 180 may be aligned with the discharge hole 130C (see FIG. 10). Air in the channel DA may be introduced into the inlet 180a of the fan 180 through the discharge hole 130C.

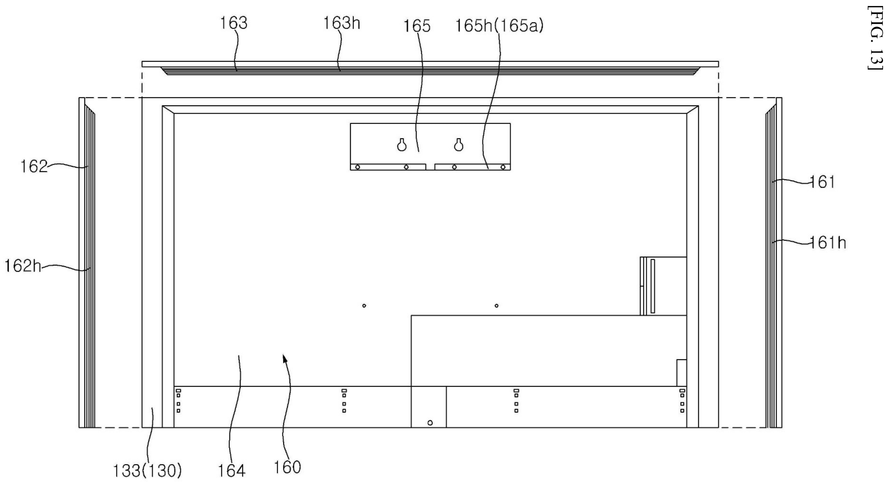

Referring to FIGS. 13 to 15, the back cover 160 may have an area corresponding to the mount plate 150 or the frame 130, and may cover the mount plate 150 or the frame 130. The back cover 160 may be coupled to the mount plate 150 and/or the frame 130. The back cover 160 may include a rear part 164, a first side part 161, a second side part 162, and a third side part 163.

The rear part 164 may define a rear surface of the back cover 160, and may be formed flat. The rear part 164 may cover the plurality of boards P1, P2, P3 and the holes 130A, 150A, 130B, 150B.

The first side part 161 may be bent from a right side of the rear part 164 toward the frame 130, and may extend along the right side of the rear part 164. The first side part 161 may cover the right side of the main board P3. A first side hole 161h may be formed through the first side part 161 in the left-right direction. The first side hole 161h may be provided in plurality. The first side hole 161h may be elongated vertically. The first side hole 161h may be positioned at the same or similar height as the first inlet hole 130A.

The second side part 162 may be bent from a left side of the rear part 164 toward the frame 130, and may extend along the left side of the rear part 164. The second side part 162 may cover the left side of the power supply board P1. A second side hole 162h may be formed through the second side part 162 in the left-right direction. The second side hole 162h may be provided in plurality. The second side hole 162h may be elongated vertically. The second side hole 162h may be positioned at the same or similar height as the second inlet hole 130B.

The third side part 163 may be bent from an upper side of the rear part 164 toward the frame 130, and may extend along the upper side of the rear part 164. The third side part 163 may cover the upper sides of the plurality of boards P1, P2, and P3. A third side hole 163h may be formed through the third side part 163 in the up-down direction. The third side hole 163h may be provided in plurality. The third side hole 163h may be elongated horizontally. A region of the third side hole 163h may correspond to the region where the plurality of boards P1, P2, and P3 are disposed. Alternatively, the region of the third side hole 163h may correspond to the region where the fan 180 is disposed.

A recessed portion 165 may be formed by being pressed forward from a rear surface of the rear part 164. The recessed portion 165 may be adjacent to the upper side of the rear part 164. A grille 165a may be a portion of the rear part 164 that defines a lower boundary of the recessed portion 165. A grille hole 165h may be formed through the grille 165a in the up-down direction, and may face the outlet 180b of the fan 180. The grille 165a may be referred to as a wall 165a.

When the fan 180 operates, air may be introduced into the channel DA through the first side hole 161h, the first through-hole 150A, and the first inlet hole 130A. In addition, air may be introduced into the channel DA through the second side hole 162h, the second through-hole 150B, and the second inlet hole 130B. The air in the channel DA may be introduced into the inlet 180a of the fan 180 through the discharge hole 130C and the inner hole. The air flowing out through the outlet 180b of the fan 180 may be discharged to the outside through the grille hole 165h and/or the third side hole 163h. The first side hole 161h may be referred to as a first intake hole 161h, and the second side hole 162h may be referred to as a second intake hole 162h. The grille hole 165h and the third side hole 163h may be referred to as exhaust holes 165h and 163h, respectively.

Accordingly, the airflow flowing through the channel DA may cool a region of the display panel 110 corresponding to the channel DA, namely, the region CA (see FIG. 5).

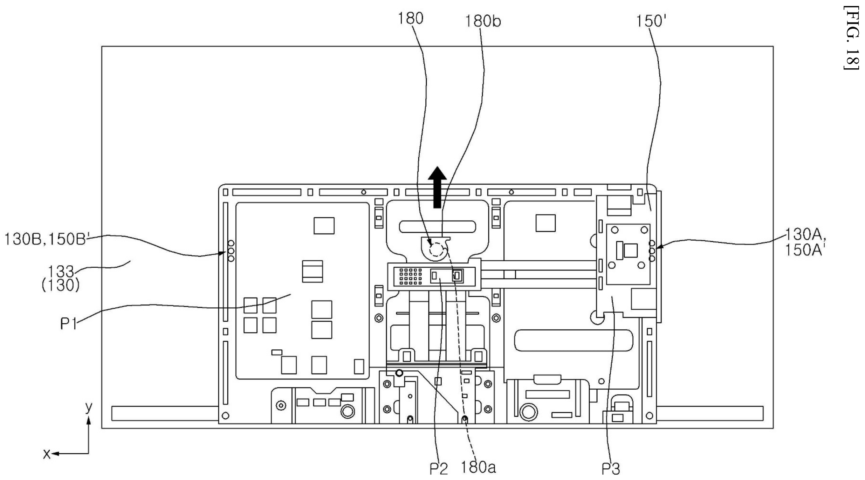

Referring to FIG. 18, a mount plate 150' may be coupled to the rear surface 133 of the frame 130. The mount plate 150' may have an area corresponding to the back cover 160' (see FIG. 6). The mount plate 150' may be referred to as a PCB plate 150'. A plurality of boards P1, P2, and P3 may be mounted on a rear surface of the mount plate 150'. Alternatively, the mount plate 150' may be omitted, and the plurality of boards P1, P2, and P3 may be mounted on the rear surface 133 of the frame 130.

For example, a portion of the mount plate 150' may be disposed in a region where the inlet hole 130A, 130B of the frame 130 are formed. In this case, a through-hole 150A', 150B' may be formed through the mount plate 150' in the front-rear direction, and may be aligned with the inlet hole 130A, 130B. In addition, the through-hole 150A', 150B' may be provided in plurality, like the inlet hole 130A, 130B (see FIG. 18) or may be elongated vertically (not shown).

As another example, the mount plate 150' may be omitted or the mount plate 150' may be disposed beyond the region in which the inlet hole 130A, 130B of the frame 130 are formed.

A fan 180 may be adjacent to the plurality of boards P1, P2, and P3. The fan 180 may be positioned at or near a central portion of a region where the plurality of boards P1, P2, and P3 are disposed. The plurality of boards P1, P2, and P3 may be horizontally arranged at a central portion of the display device, and the fan 180 may be disposed at the central portion of the display device. The fan 180 may be positioned above the timing controller board P2. The fan 180 may cause a flow of air. An inlet 180a of the fan 180 may face the front of the frame 130, and an outlet 180b of the fan 180 may face upward at the rear of the frame 130.

For example, the fan 180 may be mounted on the rear surface of the mount plate 150'. In this case, an inner hole (not shown) may be formed through the mount plate 150' in the front-rear direction, and may be positioned between the discharge hole 130C (see FIG. 10) and the inlet 180a of the fan 180. Air in the channel DA may be introduced into the inlet 180a of the fan 180 through the discharge hole 130C and the inner hole.

As another example, the fan 180 may be mounted on the rear surface 133 of the frame 130. In this case, the inlet 180a of the fan 180 may be aligned with the discharge hole 130C (see FIG. 10). Air in the channel DA may be introduced into the inlet 180a of the fan 180 through the discharge hole 130C.

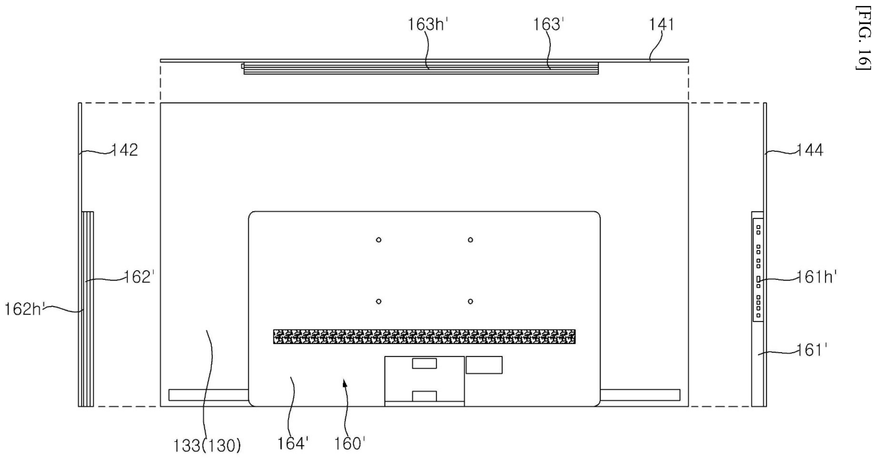

Referring to FIGS. 16 to 18, the back cover 160' may have an area corresponding to a coupling region of the frame 130 where the mount plate 150' or the plurality of boards P1, P2, and P3 are disposed, and may cover the coupling region of the mount plate 150' or the frame 130. The back cover 160' may be coupled to the mount plate 150' and/or the frame 130. The back cover 160' may include a rear part 164', a first side part 161', a second side part 162', and a third side part 163'.

The rear part 164' may define a rear surface of the back cover 160', and may be formed flat. The rear part 164' may cover the plurality of boards P1, P2, P3 and the holes 130A, 150A', 130B, 150B'.

The first side part 161' may be bent from a right side of the rear part 164' toward the frame 130, and may extend along the right side of the rear part 164'. The first side part 161' may cover the right side of the main board P3. A first side hole 161h' may be formed through the first side part 161' in the left-right direction. The first side hole 161h' may be provided in plurality. The first side hole 161h' may be elongated vertically. The first side hole 161h' may be positioned at the same or similar height as the first inlet hole 130A.

The second side part 162' may be bent from a left side of the rear part 164' toward the frame 130, and may extend along the left side of the rear part 164'. The second side part 162' may cover the left side of the power supply board P1. A second side hole 162h' may be formed through the second side part 162' in the left-right direction. The second side hole 162h' may be provided in plurality. The second side hole 162h' may be elongated vertically. The second side hole 162h' may be positioned at the same or similar height as the second inlet hole 130B.

The third side part 163' may be bent from an upper side of the rear part 164' toward the frame 130, and may extend along the upper side of the rear part 164'. The third side part 163' may cover the upper sides of the plurality of boards P1, P2, and P3. A third side hole 163h' may be formed through the third side part 163' in the up-down direction. The third side hole 163h' may be provided in plurality. The third side hole 163h' may be elongated horizontally. A region of the third side hole 163h' may correspond to the region where the plurality of boards P1, P2, and P3 are disposed. Alternatively, the region of the third side hole 163h' may correspond to the region where the fan 180 is disposed.

When the fan 180 operates, air may be introduced into the channel DA through the first side hole 161h', the first through-hole 150A', and the first inlet hole 130A. In addition, air may be introduced into the channel DA through the second side hole 162h', the second through-hole 150B', and the second inlet hole 130B. The air in the channel DA may be introduced into the inlet 180a of the fan 180 through the outlet discharge 130C and the inner hole. The air flowing out through the outlet 180b of the fan 180 may be discharged to the outside through the third side hole 163h'. The first side hole 161h' may be referred to as a first intake hole 161h', and the second side hole 162h' may be referred to as a second intake hole 162h'. The third side hole 163h' may be referred to as an exhaust hole 163h'. Meanwhile, a recessed portion like the recessed portion 165 (see FIG. 13) may be formed in the back cover 160', and may provide an air exhaust hole like the grille hole 165h (see FIG. 13).

Accordingly, the airflow flowing through the channel DA may cool a region of the display panel 110 corresponding to the channel DA, namely, the region CA (see FIG. 7).

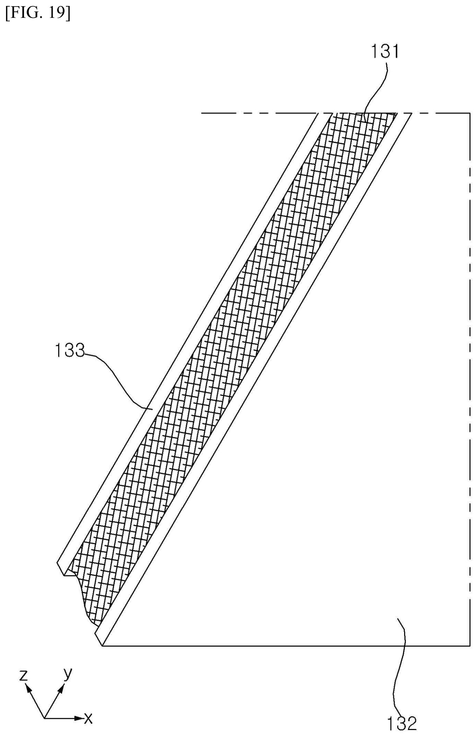

Referring to FIG. 19, the frame 130 may include a core 131, a front skin 132, and a rear skin 133. The core 131, the front skin 132, and the rear skin 133 may be coupled to each other. The frame 130 may be referred to as a material complexed panel 130, a fiber complexed panel 130, a fiber complexed plate 130, or a material complexed plate 130.

The front skin 132 may define the front surface of the frame 130. The rear skin 133 may define the rear surface of the frame 130. The front skin 132 and the rear skin 133 may include a metal material. For example, the front skin 132 and the rear skin 133 may be made of galvanized iron. As another example, the front skin 132 and the rear skin 133 may include aluminum (Al).

The core 131 may be positioned between the front skin 132 and the rear skin 133. The core 131 may include fibers. The core 131 may be formed of a composite material. The core 131 may include a main fiber and a binder fiber. The binder fiber may be mixed with the main fiber.

The front skin 132 and/or the rear skin 133 may be coupled to the core 131 by hot-melt processing. A hot-melt sheet may be disposed between the front skin 132 and the core 131, and a hot-melt sheet may be disposed between the rear skin 133 and the core 131. The hot-melt sheet may be a film.

Accordingly, it is possible to increase bending rigidity and/or torsional rigidity of the display device.

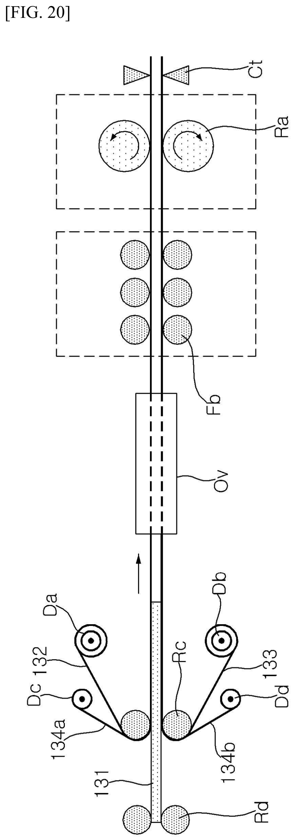

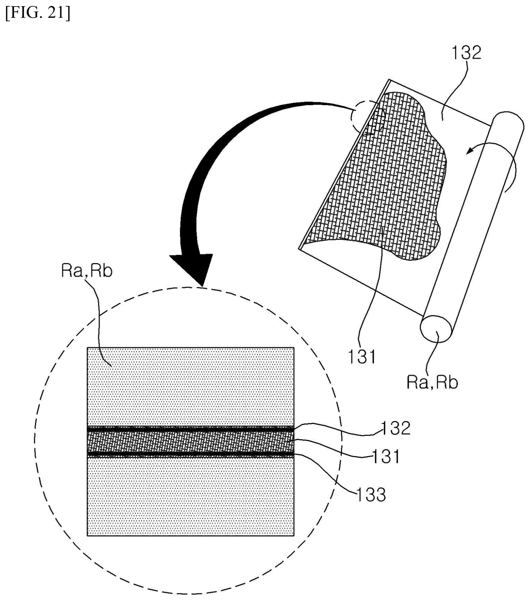

Referring to FIGS. 20 and 21, the frame 130 may be manufactured by a process of pressing the front skin 132 and the rear skin 133 onto the core 131 using a plurality of rollers. Such a process may be referred to as a Roll-to-Roll process.

Referring to FIG. 20, as a pinch roller Ra serving as a drive motor rotates, the front skin 132 may be unwound from a front drum Da, the rear skin 133 may be unwound from a rear drum Db, and the core 131 may be moved by passing through a feeding roller Rd. In addition, a first adhesive 134a for coupling the front skin 132 to the core 131 may be unwound from a first drum Dc. Also, a second adhesive 134b for coupling the rear skin 133 to the core 131 may be unwound from a second drum Db. In this case, the front skin 132, the first adhesive 134a, the core 131, the second adhesive 134b, and the rear skin 133 are stacked in this order, and may be guided toward an oven Ov by a guide roller Rc. The adhesive 134a, 134b may be a hot-melt sheet 134a, 134b.

As the first and second adhesives 134a and 134b are melted in the oven Ov, each of the front skin 132 and the rear skin 133 may be coupled to the core 131. The front skin 132, the core 131, and the rear skin 133 that have passed through the oven Ov may be guided to a press roller Rb by the rotation of the pinch roller Ra so as to be pressed by the press roller Rb. Accordingly, the coupling force among the front skin 132, the core 131, and the rear skin 133 may be further increased. The front skin 132, the core 131, and the rear skin 133, which are coupled together, may pass through the pinch roller Ra, and then may be cut by a cutter Ct to be manufactured as a frame 130 of a predetermined size.

Referring to FIG. 21, the press roller Rb or the pinch roller Ra may come into contact with an outer surface of each of the front skin 132 and the rear skin 133. When the press roller Rb or the pinch roller Ra rotates, the frame 130 may be moved in a longitudinal direction of the core 131. Here, the front skin 132 and the rear skin 133 may be sequentially coupled from one end to the other end of the core 131 in the longitudinal direction of the core 131.

Meanwhile, in addition to the Roll-to-Roll process described above with reference to FIGS. 20 and 21, which is used for making the front skin 132 and the rear skin 133 flat, a process of sequentially stacking the front skin 132, the core 131, and the rear skin 133 followed by coupling the same may also be used.

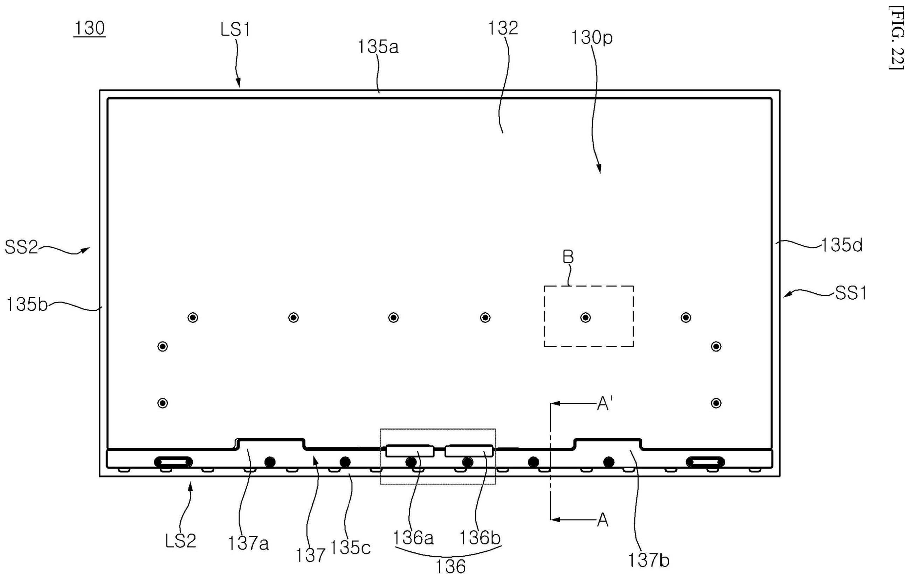

Referring to FIG. 22, the frame 130 may include a flat plate part 130P, a receiving part 137, and an outer part 135. The outer part 135 may be formed around the flat plate part 130P. A first outer part 135a may be formed along an upper side of the flat plate part 130P, a second outer part 135b may be formed along a right side of the flat plate part 130P, a third outer part 135c may be formed along a lower side of the flat plate part 130P, and a fourth outer part 135d may be formed along a left side of the flat plate part 130P. The outer part 135 may be formed in such a manner that the flat plate part 130P is pressed. The outer part 135 may be lowered from the flat plate part 130P, thereby forming a step. A thickness of the flat plate part 130P may be greater than a thickness of the outer part 135.

A cable hole 136 may be formed through the front skin 132 (see FIG. 19) and the rear skin 133 (see FIG. 19) of the receiving part 137. The cable hole 136 may be formed in the receiving part 137 adjacent to the lower side of the flat plate part 130P. The cable hole 136 may be provided in plurality. A first cable hole 136a and a second cable hole 136b may be positioned adjacent to each other.

The receiving part 137 may be formed between the flat plate part 130P and the third outer part 135c, adjacent to the lower side of the flat plate part 130P. The receiving part 137 may be provided in plurality. A first receiving part 137a may be positioned between the first cable hole 136a and the second short side SS2. A second receiving part 137b may be positioned between the second cable hole 136b and the first short side SS1. The receiving part 137 may be formed in such a manner that the flat plate part 130P is pressed. The receiving part 137 may be lowered from the flat plate part 130P and/or the outer part 135c, thereby forming a step.

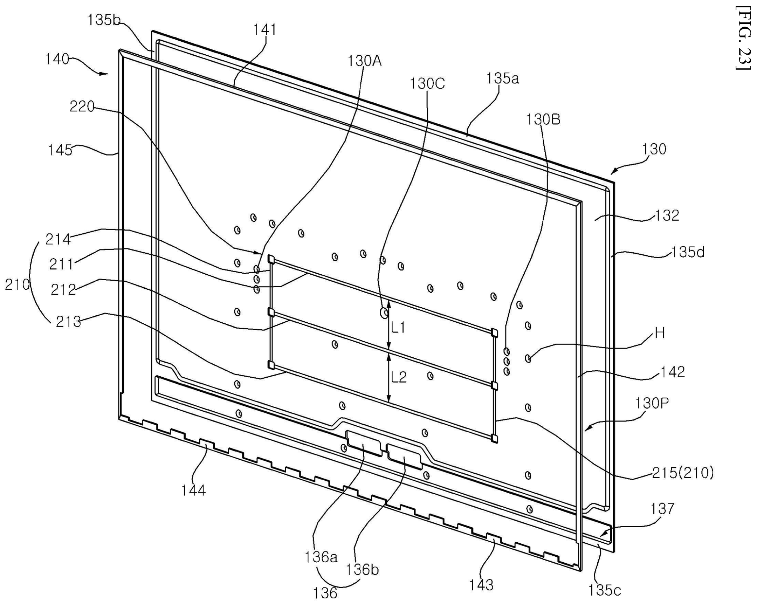

Referring to FIG. 23, the guide panel 140 may be coupled to the outer part 135 adjacent to the flat plate part 130P. The guide panel 140 may include a first part 141, a second part 142, a third part 143, a fourth part 144, and a fifth part 145.

The first part 141 may extend along the first outer part 135a, and may be coupled onto the first outer part 135a.

The second part 142 may be bent downward from a left end of the first part 141, may extend along the fourth outer part 135d, and may be coupled onto the fourth outer part 135d.

The third part 143 may be bent rightward from a lower end of the second part 142, may extend along the third outer part 135c, and may be coupled onto the third outer part 135c.

The fourth part 144 may be located on the same line as the third part 143, and may be coupled to the third outer part 135c.

The fifth part 145 may be bent downward from a right end of the first part 141, may extend along the second outer part 135b, and may be coupled onto the second outer part 135b. The fourth part 144 may be bent leftward from a lower end of the fifth part 145.

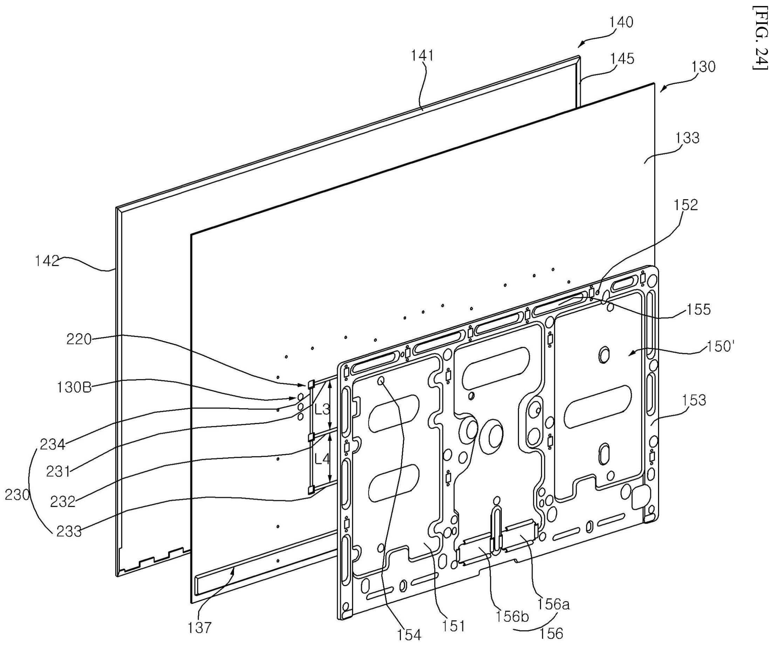

Referring to FIG. 24, the mount plate 150, 150' may be coupled to the rear of the frame 130. The mount plate 150, 150' may be coupled or fixed to the rear skin 133 of the frame 130.

A cable hole 156 may be formed through the mount plate 150, 150' in the front-rear direction, and may be aligned with the cable hole 136 (see FIG. 23).

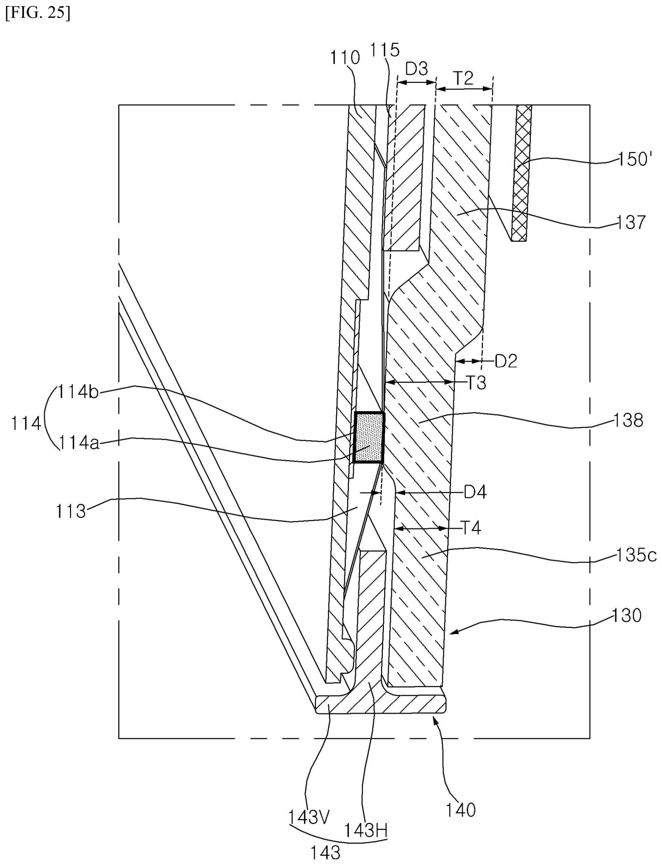

Referring to FIG. 25, the guide panel 140 may include a horizontal portion 143H and a vertical portion 143V. The horizontal portion 143H may be positioned between the display panel 110 and the frame 130, and may support the rear surface of the display panel 110. The vertical portion 143V may intersect the horizontal portion 143H, and may cover a side surface of the display panel 110 and a side surface of the frame 130.

A cable 113 may extend from the lower side of the display panel 110 toward a space between the display panel 110 and the horizontal portion 143H. For example, the cable 113 may be a chip on film (COF). A source PCB 115 may be positioned in the receiving part 137 of the frame 130, and may be electrically connected to the cable 113.

A protruding pad 138 may protrude from the frame 130 toward the display panel 110, and may be positioned between the horizontal portion 143H and the source PCB 115. A heat dissipation pad 114 may include an elastic material 114a and a conductive film 114b, and may press the cable 113 toward the protruding pad 138. Heat generated in the source PCB 115 and/or the cable 113 may be discharged through the protruding pad 138.

Referring back to FIGS. 23 and 24, an inner frame (210, 230) may be formed on the front surface and/or the rear surface of the frame 130. The inner frame (210, 230) may be referred to as a pressed frame (210, 230) or a rigid line (210, 230). The inner frame (210, 230) may be formed in such a manner that the front skin 132 and/or rear skin 133 of the frame 130 is recessed and the core 131 (see FIG. 19) is pressed.

The inner frame (210, 230) may include a front inner line 210, a rear inner line 230, and a node hole 220. The front inner line 210 may be formed in such a manner that the front skin 132 of the frame 130 is recessed. The rear inner line 230 may be formed in such a manner that the rear skin 133 of the frame 130 is recessed.

The front inner line 210 may include a first front horizontal line 211, a second front horizontal line 212, a third front horizontal line 213, a first front vertical line 214, and a second front vertical line 215. The first front horizontal line 214 may define an upper side of the front inner line 210. The third front horizontal line 213 may define a lower side of the front inner line 210. The second front horizontal line 212 may be positioned between the first front horizontal line 211 and the third front horizontal line 213. The first front vertical line 214 may connect one end of the first front horizontal line 211, one end of the second front horizontal line 212, and one end of the third front horizontal line 213. The second front vertical line 215 may connect the other end of the first front horizontal line 211, the other end of the second front horizontal line 212, and the other end of the third front horizontal line 213. For example, a first distance L1 between the first front horizontal line 211 and the second front horizontal line 212 may be less than a second distance L2 between the second front horizontal line 212 and the third front horizontal line 213.

The node hole 220 may be formed at a point where the front horizontal line 211, 212, 213 and the front vertical line 214, 215 meet. The node hole 220 may be formed through the front skin 132, the core 131, and the rear skin 133 of the frame 130.

The rear inner line 230 may include a first rear horizontal line 231, a second rear horizontal line 232, a third rear horizontal line 233, a first rear vertical line 234, and a second rear vertical line 235 (not shown). The first rear horizontal line 234 may define an upper side of the rear inner line 230. The third rear horizontal line 233 may define a lower side of the rear inner line 230. The second rear horizontal line 232 may be positioned between the first rear horizontal line 231 and the third rear horizontal line 233. The first rear vertical line 234 may connect one end of the first rear horizontal line 231, one end of the second rear horizontal line 232, and one end of the third rear horizontal line 233. The second rear vertical line 235 (not shown) may connect the other end of the first rear horizontal line 231, the other end of the second rear horizontal line 232, and the other end of the third rear horizontal line 233. For example, a third distance L3 between the first rear horizontal line 231 and the second rear horizontal line 232 may be less than a fourth distance L4 between the second rear horizontal line 232 and the third rear horizontal line 233.

The node hole 220 may be formed at a point where the rear horizontal line 231, 232, 233 and the rear vertical line 234, 235 meet. The node hole 220 may be formed through the front skin 132, the core 131, and the rear skin 133 of the frame 130.

A length of the rear inner line 230 may be less than a length of the mount plate 150, 150'. A width of the rear inner line 230 may be less than a width of the mount plate 150, 150'. The mount plate 150, 150' may cover the rear inner line 230.

Accordingly, it is possible to increase bending rigidity and/or torsional rigidity of the frame 130.

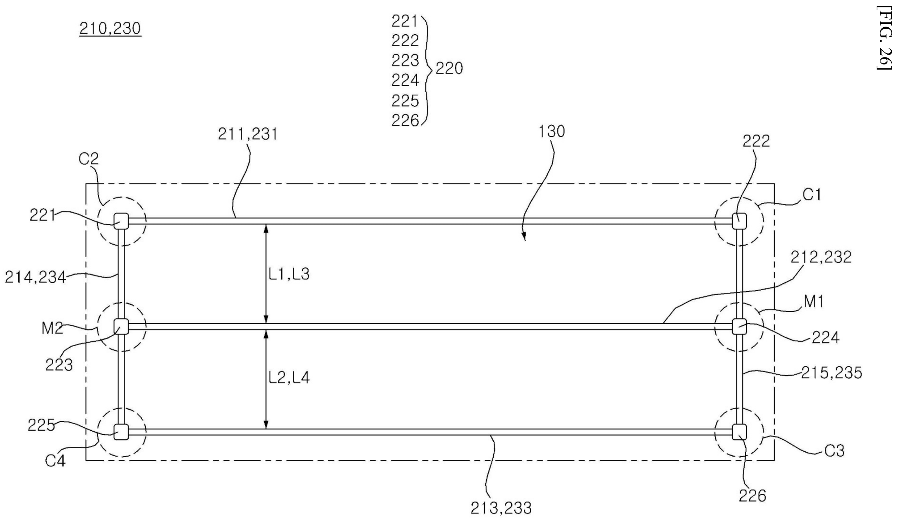

Referring to FIG. 26, a plurality of node holes 220 may be provided. The plurality of node holes 220 may include a first node hole 221, a second node hole 222, a third node hole 223, a fourth node hole 224, a fifth node hole 225, and a sixth node hole 226.

The first node hole 221 may be positioned at a corner C2 formed by the first horizontal line 211, 231 and the first vertical line 214, 234. The first node hole 221 may be formed through the frame 130 at the corner C2 of the first horizontal line 211, 231 and the first vertical line 214, 234.

The second node hole 222 may be positioned at a corner C1 formed by the first horizontal line 211, 231 and the second vertical line 212, 232. The second node hole 222 may be formed through the frame 130 at the corner C1 of the first horizontal line 211, 231 and the second vertical line 212, 232.

The third node hole 223 may be positioned at a node M2 formed by the second horizontal line 212, 232 and the first vertical line 214, 234. The third node hole 223 may be formed through the frame 130 at the node M2 of the second horizontal line 212, 232 and the first vertical line 214, 234.

The fourth node hole 224 may be positioned at a node M1 formed by the second horizontal line 212, 232 and the second vertical line 212, 232. The fourth node hole 224 may be formed through the frame 130 at the node M1 of the second horizontal line 212, 232 and the second vertical line 212, 232.

The fifth node hole 225 may be positioned at a corner C4 formed by the third horizontal line 213, 233 and the first vertical line 214, 234. The fifth node hole 225 may be formed through the frame 130 at the corner C4 of the third horizontal line 213, 233 and the first vertical line 214, 234.

The sixth node hole 226 may be positioned at a corner C3 formed by the third horizontal line 213, 233 and the second vertical line 212, 232. The sixth node hole 226 may be formed through the frame 130 at the corner C3 of the third horizontal line 213, 233 and the second vertical line 212, 232.

Accordingly, it is possible to not only increase bending rigidity and/or torsional rigidity of the frame 130, but also to improve flatness of the display panel 110 coupled to the frame 130.

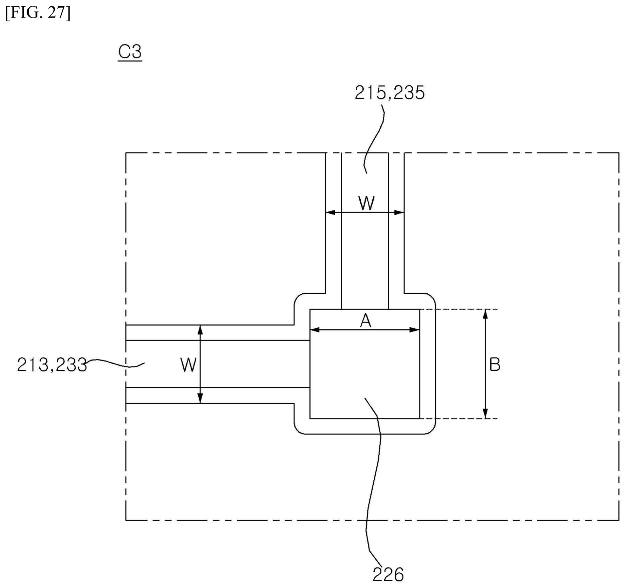

Referring to FIG. 27, the size of the sixth node hole 226 may be greater than the width of the third horizontal line 213, 233 and/or the second vertical line 215, 235. For example, when the sixth hole 226 is rectangular in shape, the sixth node hole 226 may have a width A, B greater than a width W of the third horizontal line 213, 233 and/or the second vertical line 215, 235. As another example, when the sixth node hole 226 is circular in shape, the sixth node hole 226 may have a diameter greater than the width of the third horizontal line 213, 233 and/or the second vertical line 215, 235. The description of the sixth node hole 226 is equally applicable to the first node hole 221, the second node hole 222, and/or the fifth node hole 225.

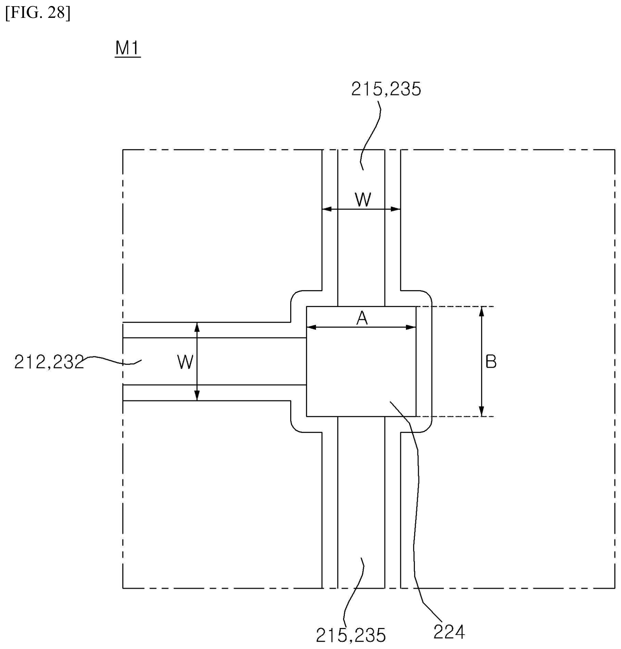

Referring to FIG. 28, the size of the fourth node hole 224 may be greater than the width of the second horizontal line 212, 232 and/or the second vertical line 215, 235. For example, when the fourth node hole 224 is rectangular in shape, the fourth node hole 224 may have a width A, B greater than a width W of the second horizontal line 212, 232 and/or the second vertical line 215, 235. As another example, when the fourth node hole 224 is circular in shape, the fourth node hole 224 may have a diameter greater than the width of the second horizontal line 212, 232 and/or the second vertical line 215, 235. The description of the fourth node hole 224 is equally appliable to the third node hole 223.

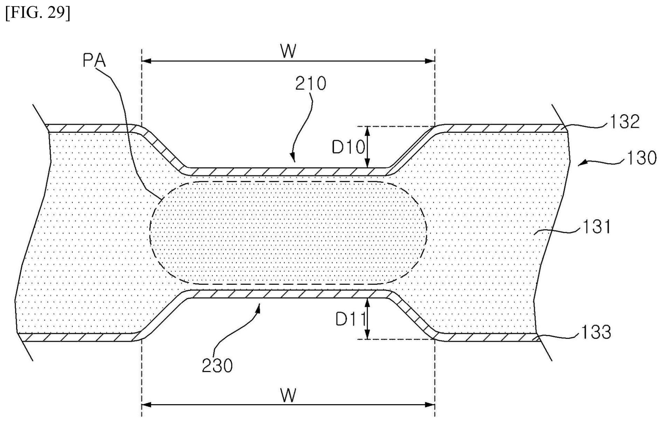

Referring to FIG. 29, as the core 131 is pressed and the front skin 132 is recessed, the front inner line 210 may be formed on the frame 130. As the core 131 is pressed and the rear skin 133 is recessed, the rear inner line 230 may be formed on the frame 130.

The front inner line 210 and the rear inner line 230 may be symmetrical with respect to the core 131. For example, a width W of the front inner line 210 may be substantially equal to a width W of the rear inner line 230. As another example, a depth D10 of the front inner line 210 may be substantially equal to a depth D11 of the rear inner line 230.

A pressed area PA caused by the core 131 being pressed may be formed between the front inner line 210 and the rear inner line 230. The density of the core 131 in the pressed area PA may be greater than the density of the core 131 in a non-pressed area.

Accordingly, it is possible to increase bending rigidity and/or torsional rigidity of the frame 130.

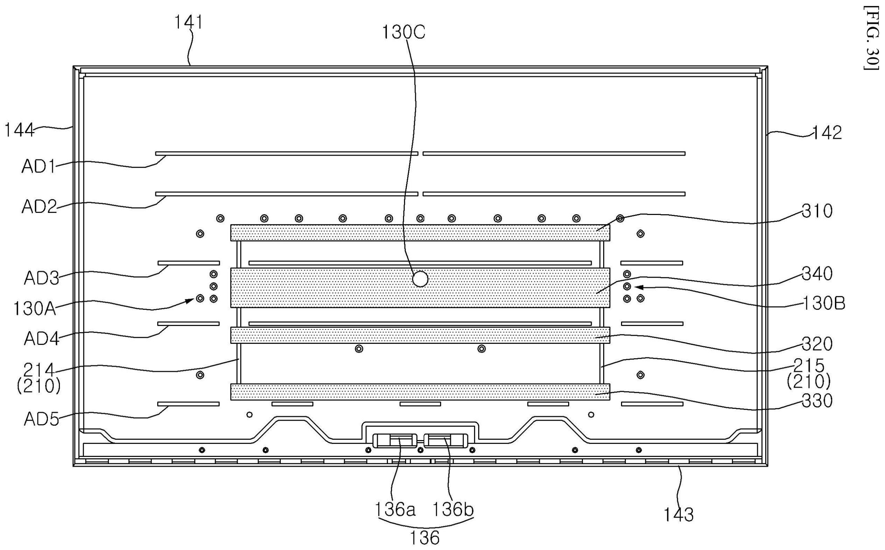

Referring to FIG. 30, a heat dissipation sheet 300 may be positioned on the front skin 132 of the frame 130. The heat dissipation sheet 300 may be attached to the flat plate part 130P of the frame 130. The heat dissipation sheet 300 may cover the front inner line 211, 212, 213 of the inner frame 210 and/or the node hole 220. For example, the heat dissipation sheet 300 may be an aluminum sheet. The heat dissipation sheet 300 may be referred to as a front heat dissipation sheet 300.

A first heat dissipation sheet 310 may extend along the first front horizontal line 211, may cover the first front horizontal line 211 and/or the node hole 220, and may be attached to the flat plate part 130P. A second heat dissipation sheet 320 may extend along the second front horizontal line 212, may cover the second front horizontal line 212 and/or the node hole 220, and may be attached to the flat plate part 130P. A third heat dissipation sheet 330 may extend along the third front horizontal line 213, may cover the third front horizontal line 213 and/or the node hole 220, and may be attached to the flat plate part 130P.

A fourth heat dissipation sheet 340 may be positioned in the channel DA between the third adhesive member AD3 and the fourth adhesive member AD4, and may be attached to the flat plate part 130P. A hole (no reference numeral) may be formed through the fourth heat dissipation sheet 340, and may be aligned with the discharge hole 130C.

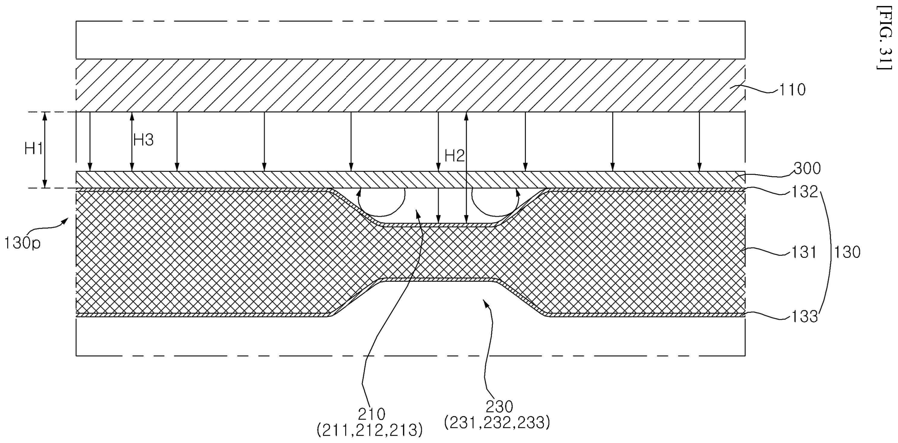

Referring to FIG. 31, the heat dissipation sheet 300 may be positioned between the display panel 110 and the frame 130. The heat dissipation sheet 300 may be in contact with the flat plate part 130P of the frame 130. The heat dissipation sheet 300 may cover the front inner line 211, 212, 213 of the inner frame 210. A gap H1 between the display panel 110 and the frame 130 may correspond to the thickness of the adhesive member AD (see FIG. 8 and FIG. 10). The heat dissipation sheet 300 may have a thickness less than the thickness of the adhesive member AD. That is, the display panel 110 may be spaced apart from the heat dissipation sheet 300 (see H3).

Heat generated from the display panel 110 may be discharged to the heat dissipation sheet 300. The heat dissipation sheet 300 may conduct and diffuse the heat generated from the display panel 110. The heat dissipation sheet 300 may transfer the heat generated from the display panel 110 to the front skin 132 of the frame 130. Accordingly, it is possible to improve the heat diffusion effect.

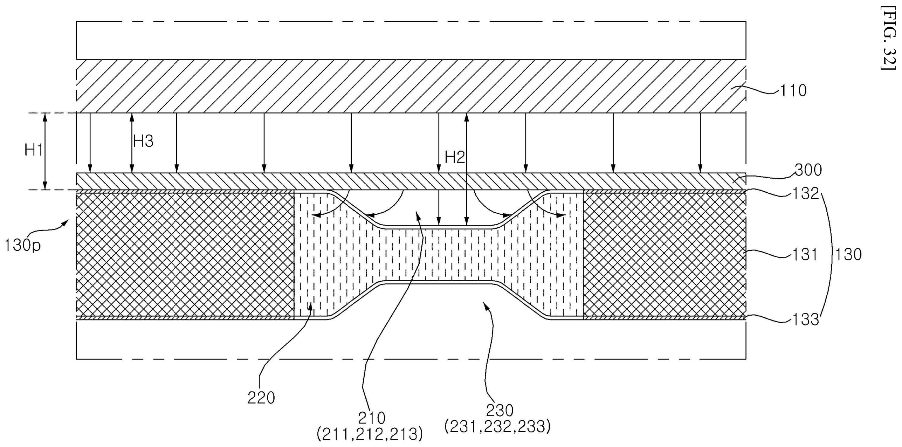

Referring to FIG. 32, the heat dissipation sheet 300 may be positioned between the display panel 110 and the frame 130. The heat dissipation sheet 300 may be in contact with the flat plate part 130P of the frame 130. The heat dissipation sheet 300 may cover the front inner line 211, 212, 213 of the inner frame 210 and the node hole 220. The display panel 110 may be spaced apart from the heat dissipation sheet 300. A gap H1 between the display panel 110 and the frame 130 may correspond to the thickness of the adhesive member AD (see FIG. 8 and FIG. 10). The heat dissipation sheet 300 may have a thickness less than the thickness of the adhesive member AD. That is, the display panel 110 may be spaced apart from the heat dissipation sheet 300 (see H3).

Heat introduced through the node hole 220 from the rear of the frame 130 may be conducted and diffused via the heat dissipation sheet 300. The heat dissipation sheet 300 may block the heat introduced through the node hole 220 from being directly transferred to the display panel 110.

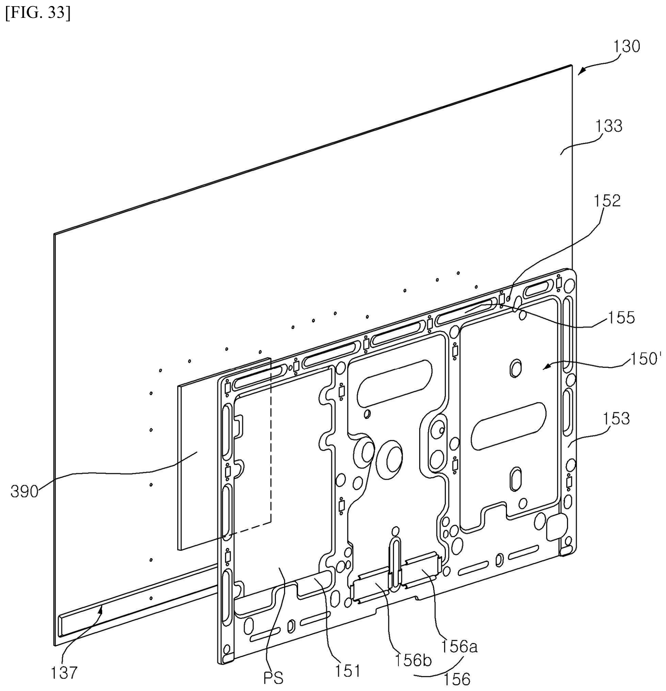

Referring to FIGS. 33 to 35, a heat dissipation sheet 390 may be positioned on the rear surface of the frame 130 between the frame 130 and the mount plate 150, 150'. The heat dissipation sheet 390 may be referred to as a rear heat dissipation sheet 390. For example, the rear heat dissipation sheet 390 may be a graphite sheet. A power supply unit PS having the power supply board P1 may be positioned at the rear of the mount plate 150, 150', and may be mounted on the mount plate 150, 150'. The rear heat dissipation sheet 390 may be aligned at the position of the power supply unit PS. For example, the rear heat dissipation sheet 390 may have an area corresponding to an area of the power supply unit PS.

The rear heat dissipation sheet 390 may be in contact with the rear skin 133 of the frame 130 and the mount plate 150, 150'. Alternatively, the rear heat dissipation sheet 390 may be attached to the rear skin 133 of the frame 130, and may form an air gap with the mount plate 150, 150'. Heat generated from the power supply unit PS may be directed toward the rear skin 133 of the frame 130 through the mount plate 150, 150'. The rear heat dissipation sheet 390 may diffuse the heat transmitted through the mount plate 150, 150'. The rear heat dissipation sheet 390 may minimize the transfer of heat to the rear skin 133 of the frame 130, and may diffuse the heat throughout the rear heat dissipation sheet 390. The core 131 of the frame 130 may block the heat transferred to the rear skin 133 via the rear heat dissipation sheet 390. Accordingly, it is possible to achieve effective heat dissipation and insulation of the display panel 110.

Referring to FIGS. 1 to 35, a display device according to an aspect of the present disclosure may include: a display panel; a frame which is positioned behind the display panel and to which the display panel is coupled; a board coupled to a rear surface of the frame; a channel which is an air flow path between the display panel and the frame, and which overlpas the board in a thickness direction of the frame; and a fan positioned opposite the channel with respect to the frame and having an inlet facing the channel, the frame may include: an inlet hole formed in the frame and communicating with the channel; and a discharge hole formed in the frame, spaced apart from the inlet hole, and positioned between the channel and the inlet of the fan.

The display device may further include: a first protruding portion protruding from a front surface of the frame toward the display panel and defining one boundary of the channel; and a second protruding portion protruding from the front surface of the frame toward the display panel and defining another boundary of the channel.

The first protruding portion may be an adhesive member attached to the front surface of the frame and a rear surface of the display panel.

The first protruding portion may be formed by being pressed forward from the rear surface of the frame.

The inlet hole and the discharge hole may be positioned between the first protruding portion and the second protruding portion.

The inlet hole may include: a first inlet hole adjacent to one end of the first protruding portion; and a second inlet hole adjacent to another end of the first protruding portion, the discharge hole may be positioned between the first inlet hole and the second inlet hole.

The inlet hole and the discharge hole may be aligned with each other in a longitudinal direction of the channel.

One end of the first protruding portion may be spaced apart from one side of the frame while being adjacent to the one side, and the inlet hole may be positioned between the one end of the first protruding portion and the one side of the frame.

One end of the first protruding portion may be in contact with one side of the frame, and the inlet hole may be adjacent to the one end of the first protruding portion.

The board may be provided in plurality, and the channel may extend along a direction in which the plurality of boards are arranged.

The plurality of boards may include: a first board adjacent to a left side of the frame; a second board adjacent to a right side of the frame; and a third board positioned between the first board and the second board, the channel may extend horizontally.

The display device may further include a back cover covering the board and a rear of the fan, and coupled to the frame, the back cover may include: an intake hole formed in the back cover and communicating with the inlet hole; and an exhaust hole formed in the back cover and communicating with an outlet of the fan.

The intake hole may include: a first intake hole; and a second intake hole, the back cover may include: a rear part defining a rear surface of the back cover; a first side part bent from a right side of the rear part toward the frame and in which the first intake hole is formed; a second side part bent from a left side of the rear part toward the frame and in which the second intake hole is formed; and a third side part bent from an upper side of the rear part toward the frame and in which the exhaust hole is formed, the inlet hole may include: a first inlet hole adjacent to the first intake hole and communicating with the first intake hole; and a second inlet hole adjacent to the second intake hole and communicating with the second intake hole.

The display device may further include a mount plate positioned between the frame and the board and on which the board is mounted, the mount plate may include: a through-hole formed in the mount plate and aligned with the inlet hole; and an inner hole formed in the mount plate and positioned between the discharge hole and the inlet of the fan.

The frame may include: a front skin defining a front surface of the frame; a rear skin defining the rear surface of the frame; a core disposed between the front skin and the rear skin and including fibers; an inner frame recessed from the front skin or the rear skin and positioned opposite the mount plate; and a heat dissipation sheet adjacent to or overlapping the inner frame and attached to the front skin, and a thickness of the heat dissipation sheet may be less than a gap between a rear surface of the display panel and the front surface of the frame.

Certain embodiments or other embodiments of the disclosure described above are not mutually exclusive or distinct from each other. Any or all elements of the embodiments of the disclosure described above may be combined or combined with each other in configuration or function.

For example, a configuration "A" described in one embodiment of the disclosure and the drawings, and a configuration "B" described in another embodiment of the disclosure and the drawings may be combined with each other. Namely, although the combination between the configurations is not directly described, the combination is possible except in the case where it is described that the combination is impossible.

The above detailed description is to be construed in all aspects as illustrative and not restrictive. The scope of the present disclosure should be determined by reasonable interpretation of the appended claims, and all changes coming within the equivalency range of the present disclosure are intended to be embraced in the scope of the present disclosure.

## Claims

1. A display device comprising:
a display panel;
a frame which is positioned behind the display panel and to which the display panel is coupled;
a board coupled to a rear surface of the frame;
a channel which is an air flow path between the display panel and the frame, and which overlaps the board in a thickness direction of the frame; and
a fan positioned opposite the channel with respect to the frame and having an inlet facing the channel,
wherein the frame comprises:
an inlet hole formed in the frame and communicating with the channel; and
a discharge hole formed in the frame, spaced apart from the inlet hole, and positioned between the channel and the inlet of the fan.

2. The display device of claim 1, further comprising:
a first protruding portion protruding from a front surface of the frame toward the display panel and defining one boundary of the channel; and
a second protruding portion protruding from the front surface of the frame toward the display panel and defining another boundary of the channel.

3. The display device of claim 2, wherein the first protruding portion is an adhesive member attached to the front surface of the frame and a rear surface of the display panel.

4. The display device of claim 2, wherein the first protruding portion is formed by being pressed forward from the rear surface of the frame.

5. The display device of claim 2, wherein the inlet hole and the discharge hole are positioned between the first protruding portion and the second protruding portion.

6. The display device of claim 5, wherein the inlet hole comprises:
a first inlet hole adjacent to one end of the first protruding portion; and
a second inlet hole adjacent to another end of the first protruding portion, and
wherein the discharge hole is positioned between the first inlet hole and the second inlet hole.

7. The display device of claim 5, wherein the inlet hole and the discharge hole are aligned with each other in a longitudinal direction of the channel.

8. The display device of claim 5, wherein one end of the first protruding portion is spaced apart from one side of the frame while being adjacent to the one side, and
wherein the inlet hole is positioned between the one end of the first protruding portion and the one side of the frame.

9. The display device of claim 5, wherein one end of the first protruding portion is in contact with one side of the frame, and
wherein the inlet hole is adjacent to the one end of the first protruding portion.

10. The display device of claim 1, wherein the board is provided in plurality, and
wherein the channel extends along a direction in which the plurality of boards are arranged.

11. The display device of claim 10, wherein the plurality of boards comprises:
a first board adjacent to a left side of the frame;
a second board adjacent to a right side of the frame; and
a third board positioned between the first board and the second board, and
wherein the channel extends horizontally.

12. The display device of claim 1, further comprising a back cover covering the board and a rear of the fan, and coupled to the frame,
wherein the back cover comprises:
an intake hole formed in the back cover and communicating with the inlet hole; and
an exhaust hole formed in the back cover and communicating with an outlet of the fan.

13. The display device of claim 12, wherein the intake hole comprises:
a first intake hole; and
a second intake hole,
wherein the back cover comprises:
a rear part defining a rear surface of the back cover;
a first side part bent from a right side of the rear part toward the frame and in which the first intake hole is formed;
a second side part bent from a left side of the rear part toward the frame and in which the second intake hole is formed; and
a third side part bent from an upper side of the rear part toward the frame and in which the exhaust hole is formed, and
wherein the inlet hole comprises:
a first inlet hole adjacent to the first intake hole and communicating with the first intake hole; and
a second inlet hole adjacent to the second intake hole and communicating with the second intake hole.

14. The display device of claim 1, further comprising a mount plate positioned between the frame and the
board and on which the board is mounted,
wherein the mount plate comprises:
a through-hole formed in the mount plate and aligned with the inlet hole; and
an inner hole formed in the mount plate and positioned between the discharge hole and the inlet of the fan.

15. The display device of claim 14, wherein the frame comprises:
a front skin defining a front surface of the frame;
a rear skin defining the rear surface of the frame;
a core disposed between the front skin and the rear skin, and including fibers;
an inner frame recessed from the front skin or the rear skin and opposite the mount plate; and
a heat dissipation sheet adjacent to or overlapping the inner frame and attached to the front skin, and
wherein a thickness of the heat dissipation sheet is less than a gap between a rear surface of the display panel and the front surface of the frame.
